**Europäisches Patentamt**

**European Patent Office**

**Office européen des brevets**

(19)

(11) **EP 1 328 008 A1**

(12) **EUROPÄISCHE PATENTANMELDUNG**

| | |
|---|---|
| (43) Veröffentlichungstag:<br>**16.07.2003 Patentblatt 2003/29** | (51) Int Cl.⁷: **H01L 21/00** |

(21) Anmeldenummer: **02000548.4**

(22) Anmeldetag: **09.01.2002**

| | |
|---|---|
| (84) Benannte Vertragsstaaten:<br>**AT BE CH CY DE DK ES FI FR GB GR IE IT LI LU MC NL PT SE TR**<br>Benannte Erstreckungsstaaten:<br>**AL LT LV MK RO SI** | (72) Erfinder:<br>• **Mannhart, Eugen, Dr.**<br>  **6330 Cham (CH)**<br>• **Schubiger, Reto**<br>  **6030 Ebikon (CH)** |
| (71) Anmelder: **ESEC Trading SA**<br>**6330 Cham (CH)** | (74) Vertreter: **Falk, Urs, Dr.**<br>**Patentanwaltsbüro Dr. Urs Falk,**<br>**Eichholzweg 9A**<br>**6312 Steinhausen (CH)** |

(54) **Klemmelement für flächige Werkstücke**

(57)     Ein Klemmelement (1) für ein flächiges Werkstück, mit einer ersten Klemmbacke (3) mit einer ersten Klemmfläche (4) und einer zweiten Klemmbacke (5) mit einer zweiten Klemmfläche (6) weist einen optischen Sensor auf für die Messung des Abstandes (d) zwischen den beiden Klemmflächen (4, 6). Der optische Sensor ist teilweise in die Klemmbacken (3, 5) integriert. Der optische Sensor umfasst einen Lichtsender (11), einen ersten Lichtleiter (10) und einen zweiten Lichtleiter (12) und mindestens einen Photosensor (13; 13.1, 13.2). Die erste Klemmbacke (3) weist eine Bohrung (8) auf, die ein Ende des ersten Lichtleiters (10) aufnimmt und die zweite Klemmbacke (5) weist eine Bohrung (9) auf, die den zweiten Lichtleiter (12) aufnimmt.

Fig. 1

EP 1 328 008 A1

**Beschreibung**

Die Erfindung betrifft ein Klemmelement für flächige Werkstücke der im Oberbegriff des Anspruchs 1 genannten Art.

Ein Klemmelement der im Oberbegriff des Anspruchs 1 genannten Art ist aus dem schweizerischen Patent CH 679 878 bekannt. Eine Weiterentwicklung eines solchen Klemmelementes ist im schweizerischen Patent CH 689 188 beschrieben.

Solche Klemmelemente werden vorteilhaft bei Montageautomaten für die Montage und Verdrahtung von Halbleitern, z.B. bei Die Bondern oder Wire Bondern, für den Transport der Substrate verwendet. Die Substrate werden in der Regel in Magazinen bereitgestellt und nacheinander der Transportvorrichtung des Montageautomaten zugeführt. Dabei kommt es vor, dass zwei Substrate aneinander kleben und deshalb gemeinsam der Transportvorrichtung zugeführt und von den Klemmelementen miteinander transportiert werden. Um hochwertige Substrate optimal gegen Beschädigungen zu schützen, wird oftmals zwischen je zwei Substrate ein Streifen Papier oder Folie in das Magazin eingelegt. Bei der Zuführung der Substrate zur Transportvorrichtung kann es dann vorkommen, dass anstelle des Substrates der Streifen Papier bzw. Folie zugeführt wird oder dass das Substrat und der Streifen Papier bzw. Folie zugeführt werden.

Der Erfindung liegt die Aufgabe zugrunde, einen Sensor zu entwickeln, um derartige Fehler zuverlässig und frühzeitig erkennen zu können.

Die genannte Aufgabe wird erfindungsgemäss gelöst durch die Merkmale des Anspruchs 1. Die Erfindung besteht darin, ein Klemmelement der Transportvorrichtung mit einem optischen Sensor zu versehen, dessen Ausgangssignal proportional zum Abstand der Klemmflächen des Klemmelementes ist. Der optische Sensor umfasst gemäss einer bevorzugten Variante einen Lichtsender, einen ersten Lichtleiter und einen zweiten Lichtleiter und mindestens einen Photosensor. Das Klemmelement hat zwei Klemmbacken. Die erste Klemmbacke weist eine Bohrung auf, die ein Ende des ersten Lichtleiters aufnimmt und die zweite Klemmbacke weist eine Bohrung auf, die den zweiten Lichtleiter aufnimmt. Die beiden Klemmbacken nehmen also je ein Teil des optischen Sensors auf. Der erste Lichtleiter leitet einen Lichtstrahl vom Lichtsender zum zweiten Lichtleiter, der das auffallende Licht zum Lichtempfänger leitet. Der Einfallswinkel, unter dem der Lichtstrahl auf den zweiten Lichtleiter auftrifft, hängt vom Öffnungswinkel der Klemmbacken und somit von der Dicke des eingeklemmten Gegenstandes ab. Mit dem Einfallswinkel ändert sich der Anteil des Lichts, das auf den zweiten Lichtleiter auftrifft, so dass die vom Lichtempfänger gemessene Lichtintensität ein Mass für die Dicke des eingeklemmten Gegenstandes ist.

Gemäss einer weiteren Variante entfallen die beiden Lichtleiter: der Lichtsender und der Lichtempfänger sind direkt in die Klemmbacken integriert.

Nachfolgend werden drei Ausführungsbeispiele der Erfindung anhand der nicht massstabsgetreuen Zeichnung näher erläutert.

Es zeigen:

Fig. 1 ein erstes Ausführungsbeispiel eines erfindungsgemässen Klemmelementes in seitlicher Ansicht,

Fig. 2 ein zweites Ausführungsbeispiel eines erfindungsgemässen Klemmelementes in Aufsicht, und

Fig. 3 ein drittes Ausführungsbeispiel eines erfindungsgemässen Klemmelementes in seitlicher Ansicht.

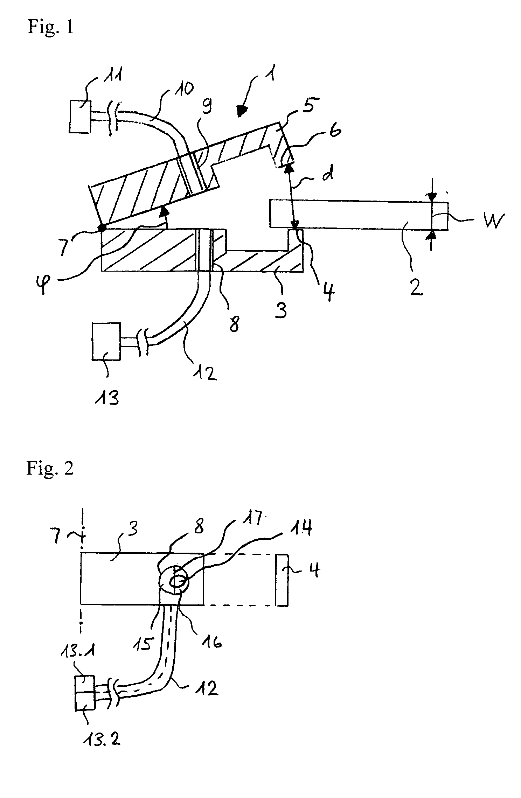

Die Fig. 1 zeigt schematisch und in seitlicher Ansicht ein erstes Ausführungsbeispiel eines Klemmelementes 1 zum Festhalten eines flächigen Werkstücks, z.B. eines Substrates 2 in der Form eines Leadframes oder BGA®, etc.. Das Klemmelement 1 weist eine erste Klemmbacke 3 mit einer ersten Klemmfläche 4 und eine zweite Klemmbacke 5 mit einer zweiten Klemmfläche 6 auf. Die beiden Klemmflächen 4 und 6 liegen einander gegenüber. Die erste Klemmbacke 3 ist fest angeordnet. Die zweite Klemmbacke 5 ist um eine horizontale Achse 7 drehbar. Zum Klemmen wird sie beispielsweise mittels eines elektrischen, pneumatischen oder hydraulischen Antriebs entgegen der Kraft einer Rückstellfeder betätigt. Der Winkel φ zwischen den beiden Klemmbacken 3 und 5 ist proportional zum Abstand d zwischen den beiden Klemmflächen 4 und 6. Wenn also das Substrat 2 zwischen den Klemmbacken 3 und 5 eingeklemmt ist, dann ist der Winkel φ proportional zur Dicke W des Substrates 2.

Die beiden Klemmbacken 3 und 5 weisen je eine Bohrung 8 bzw. 9 auf, die im geschlossenen Zustand des Klemmelementes 1 und sofern kein Substrat festgeklemmt ist, koaxial verlaufen. Die Bohrung 9 nimmt das Ende eines ersten Lichtleiters 10 auf, der mit Licht aus einem Lichtsender 11, beispielsweise einer Leuchtdiode oder einer Laserdiode, gespeist wird. Die Bohrung 8 nimmt das Ende eines zweiten Lichtleiters 12 auf, der das auf die Stirnseite dieses Endes des Lichtleiters 12 fallende Licht zu einem Photosensor 13 leitet. Die beiden Lichtleiter 10 und 12 sind typischerweise rund und ihr Durchmesser beträgt typisch 0.1 mm oder weniger.

Wenn sich die beiden Klemmflächen 4 und 6 berühren, trifft der vom ersten Lichtleiter 10 ausgesandte Lichtstrahl senkrecht und daher vollständig auf den zweiten Lichtleiter 12 auf. Wenn hingegen der Winkel φ nicht verschwindet, weil die Klemmbacken 3 und 5 das Substrat 2 einklemmen, dann trifft der vom ersten Lichtleiter 10 ausgesandte Lichtstrahl schräg unter dem Winkel φ und daher nur teilweise auf den zweiten Lichtleiter 12 auf, während der restliche Anteil auf die den zweiten Lichtleiter 12 umgebende Fläche der Klemmbacke 3 auftrifft. Der auf den zweiten Lichtleiter 12 auftreffende Anteil des Lichtstrahls ist maximal, wenn der Winkel φ gleich Null ist, und nimmt mit zunehmendem Winkel φ und somit mit zunehmendem Abstand d der beiden Klemmflächen 4 und 6 kontinuierlich ab. Das Signal U des Photosensors 13 ist somit eine in Funktion des Abstandes d der beiden Klemmflächen 4 und 6 monoton fallende Funktion.

Bei einem zweiten Ausführungsbeispiel besteht der zweite Lichtleiter 12 aus zwei Lichtfasern 15 und 16 (oder zwei Faserbündeln), die das auftreffende Licht zu zwei Photosensoren 13.1 und 13.2 leiten. Dieses Ausführungsbeispiel hat den gleichen Aufbau wie das in der Fig. 1 dargestellte erste Ausführungsbeispiel. Davon abweichende Details werden anhand der Fig. 2 erläutert. Die Fig. 2 zeigt in Aufsicht die Klemmbacke 3 und den zweiten Lichtleiter 12, sowie die vom Lichtstrahl bei einem bestimmten Wert $\varphi_1$ des Winkels φ beleuchtete Fläche 14. Die Trennlinie 17 zwischen den beiden Lichtfasern 15 und 16 verläuft annähernd parallel zur Drehachse 7 der zweiten Klemmbacke 5 (Fig. 1). Der Durchmesser des zweiten Lichtleiters 12 ist grösser als der Durchmesser des ersten Lichtleiters 10. Ausgehend vom Winkel φ = 0, wo wegen der koaxialen Anordnung der beiden Bohrungen 8 und 9 (Fig. 1) beide Lichtfasern 15 und 16 etwa gleich stark beleuchtet werden, wird die erste Lichtfaser 15 mit zunehmendem Winkel φ weniger stark und die zweite Lichtfaser 16 mit zunehmendem Winkel φ stärker beleuchtet. Als Signal U zur Bestimmung des Abstandes d der beiden Klemmflächen 4 und 6 dient nun die Differenz der von den beiden Photosensoren 13.1 und 13.2 gelieferten Ausgangssignale $U_1$ und $U_2$:

$$U = U_2 - U_1. \qquad (1)$$

In diesem Fall ist das Signal U eine in Funktion des Abstandes d der beiden Klemmflächen 4 und 6 monoton ansteigende Funktion.

Der Lichtsender 11, die beiden Lichtleiter 10 und 12 und der Photosensor 13 bzw. die beiden Photosensoren 13.1 und 13.2 bilden einen optischen Sensor zur Messung der Dicke des zwischen den Klemmbacken 3 und 5 eingeklemmten Gegenstandes. Mittels einer Eichung kann die Beziehung zwischen dem Signal U und dem Abstand d zwischen den Klemmflächen 4 und 6 ermittelt und gespeichert werden.

Die Empfindlichkeit des Sensors kann erhöht und der Einfluss von Fremdlicht verringert werden, wenn die an sich bekannte Lock-in Technik angewandt wird, bei der das vom Lichtsender abgestrahlte Licht moduliert wird.

Das bisher schematisch beschriebene Klemmelement kann auf verschiedene Weise realisiert werden. Für den Einsatz zum Transport von flächigen Substraten auf einem Die Bonder oder Wire Bonder eignet sich besonders ein Klemmelement, das gemäss den in der Einleitung zitierten Patentschriften CH 679 878 und CH 689 188 konstruiert ist. Eine mit solchen Klemmelementen versehene Transportvorrichtung ist aus dem europäischen Patent EP 330 831 bekannt. Für die Detektion, ob das Substrat richtig zugeführt wird, wird bei dieser Transportvorrichtung das erste Klemmelement mit dem optischen Sensor gemäss einem der beiden Ausführungsbeispiele ausgerüstet.

Im Betrieb des Montageautomaten wird das beim ersten Ausführungsbeispiel vom Photosensor 13 (Fig. 1) gelieferte Signal U bzw. beim zweiten Ausführungsbeispiel aus den Photosensoren 13.1 und 13.2 (Fig. 2) gemäss Gleichung (1) abgeleitete Signal U digitalisiert und ausgewertet, sobald das Klemmelement 1 ein zugeführtes Substrat 2 zum erstenmal festklemmt. Bei der Auswertung wird geprüft, ob der gemessene Abstand d der erwarteten Dicke W des Substrates 2 entspricht. Falls dies nicht der Fall ist, dann bestehen folgende Möglichkeiten:

A) Es wurde ein falsches Substrat zugeführt.
B) Es wurden zwei aneinander haftende Substrate zugeführt.
C) Es wurden ein Substrat und ein Streifen Papier bzw. Folie zugeführt.
D) Es wurde nur ein Streifen Papier bzw. Folie zugeführt.
E) Die Klemmbacke 5 schliesst nicht mehr. Dies ist dann der Fall, wenn das gemessen Signal U gleich dem Signal im geöffneten Zustand des Klemmelementes 1 ist. Ursache könnte ein Defekt im Antrieb sein.

Falls ein solcher Fehler detektiert wird, wird ein Alarm erzeugt oder der Gegenstand wird von der Transportvorrichtung ohne Prozessbearbeitung, d.h. z.B. ohne Die oder Wire Bonden, zum Ausgang befördert.

Mit zunehmender Abnützung der Klemmbacken ändert sich auch das Signal U im geschlossenen Zustand des Klemmelementes 1, wenn kein Substrat eingeklemmt wird. Mit periodischen Tests lässt sich somit auch eine Abnützung der Klemmbacken feststellen.

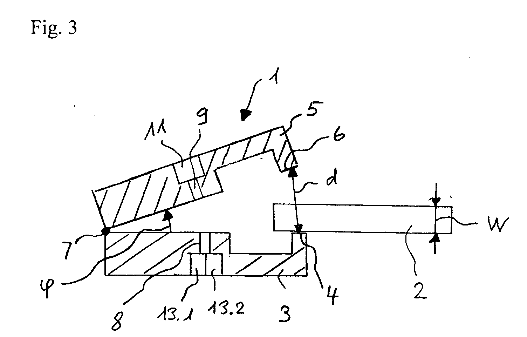

Die Fig. 3 zeigt schematisch und in seitlicher Ansicht ein drittes Ausführungsbeispiel des Klemmelementes 1, bei dem die Lichtleiter entfallen. Die Bohrungen 8 und 9 sind auf der der Klemmfläche abgewandten Seite aufgeweitet: Die Bohrung 9 nimmt den Lichtsender 11 auf, die Bohrung 8 nimmt entweder einen einzigen Photosensor 13 oder zwei Photosensoren 13.1 und 13.2 auf. Falls zwei Photosensoren vorhanden sind, verläuft die Trennlinie zwischen ihnen analog zum zweiten Ausführungsbeispiel so, dass als Signal U zur Bestimmung des Abstandes d der beiden Klemmflächen 4 und 6 wieder die Differenz der von den beiden Photosensoren 13.1 und 13.2 gelieferten Ausgangssignale $U_1$ und $U_2$ gemäss Gleichung (1) verwendet werden kann. Die den Klemmflächen 4 bzw. 6 zugewandten, verjüngten Seiten der Bohrungen 8 und 9 haben die Aufgabe, das Licht ähnlich zu leiten und zu bündeln wie es die Lichtleiter bei den anderen Ausführungsbeispielen tun.

**Patentansprüche**

1. Klemmelement (1) für ein flächiges Werkstück, mit einer ersten Klemmbacke (3) mit einer ersten Klemmfläche (4) und einer zweiten Klemmbacke (5) mit einer zweiten Klemmfläche (6), **dadurch gekennzeichnet, dass** die beiden Klemmbacken (3, 5) je ein Teil eines optischen Sensors für die Messung des Abstandes (d) zwischen den beiden Klemmflächen (4, 6) aufnehmen.

2. Klemmelement nach Anspruch 1, **dadurch gekennzeichnet, dass** der optische Sensor einen Lichtsender (11), einen ersten Lichtleiter (10) und einen zweiten Lichtleiter (12) und mindestens einen Photosensor (13; 13.1, 13.2) umfasst, dass die erste Klemmbacke (3) eine Bohrung (8) aufweist, die ein Ende des zweiten Lichtleiters (12) aufnimmt, und dass die zweite Klemmbacke (5) eine Bohrung (9) aufweist, die den ersten Lichtleiter (10) aufnimmt.

3. Klemmelement nach Anspruch 2, **dadurch gekennzeichnet, dass** der zweite Lichtleiter (12) mindestens zwei Lichtfasern (15, 16) umfasst, die auftreffendes Licht zu zwei getrennten Photosensoren (13.1, 13.2) leiten.

4. Klemmelement nach Anspruch 1, **dadurch gekennzeichnet, dass** der optische Sensor einen Lichtsender (11) und mindestens einen Photosensor (13; 13.1, 13.2) umfasst, dass die erste Klemmbacke (3) eine Bohrung (8) aufweist, die den mindestens einen Photosensor (13; 13.1, 13.2) aufnimmt und auf der der ersten Klemmfläche (4) zugewandten Seite verjüngt ist, und dass die zweite Klemmbacke (5) eine Bohrung (9) aufweist, die den Lichtsender (11) aufnimmt und auf der der zweiten Klemmfläche (6) zugewandten Seite verjüngt ist.

Fig. 1

Fig. 2

Fig. 3

**Europäisches Patentamt**

# EUROPÄISCHER RECHERCHENBERICHT

Nummer der Anmeldung

EP 02 00 0548

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 6 203 084 B1 (KRUK ET AL.) 20. März 2001 (2001-03-20) * Zusammenfassung; Abbildungen 1,2 * --- | 1 | H01L21/00 |
| A | US 3 827 963 A (CALLAHAN ET AL.) 6. August 1974 (1974-08-06) * Abbildung 2 * * Spalte 3, Zeile 18-45 * ----- | 1 | |

RECHERCHIERTE SACHGEBIETE (Int.Cl.7)

H01L
G01B
B65H
H05K

Der vorliegende Recherchenbericht wurde für alle Patentansprüche erstellt

| Recherchenort | Abschlußdatum der Recherche | Prüfer |
|---|---|---|
| DEN HAAG | 7. Juni 2002 | Oberle, T |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.................................................................................................
& : Mitglied der gleichen Patentfamilie, übereinstimmendes Dokument

EPO FORM 1503 03.82 (P04C03)

# EP 1 328 008 A1

## ANHANG ZUM EUROPÄISCHEN RECHERCHENBERICHT
## ÜBER DIE EUROPÄISCHE PATENTANMELDUNG NR.

EP 02 00 0548

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

07-06-2002

| Im Recherchenbericht angeführtes Patentdokument | Datum der Veröffentlichung | Mitglied(er) der Patentfamilie | Datum der Veröffentlichung |
|---|---|---|---|
| US 6203084 B1 | 20-03-2001 | AU 2752800 A<br>WO 0045977 A1 | 25-08-2000<br>10-08-2000 |
| US 3827963 A | 06-08-1974 | KEINE | |